Europäisches Patentamt

(19) European Patent Office

Office européen des brevets

(11) Publication number: **0 453 253 A2**

# (12) EUROPEAN PATENT APPLICATION

(21) Application number: **91303410.4**

(22) Date of filing: **17.04.91**

(51) Int. Cl.⁵: **H04L 7/033, G11B 20/14**

(30) Priority: **20.04.90 US 511688**

(43) Date of publication of application:
**23.10.91 Bulletin 91/43**

(84) Designated Contracting States:
**DE FR GB**

(71) Applicant: **International Business Machines Corporation**
**Old Orchard Road**
**Armonk, N.Y. 10504 (US)**

(72) Inventor: **Bailey, James Arthur**
**4100 N. Tortolita Road**
**Tucson, Arizona 85745 (US)**
Inventor: **Gooding, Gary Francis**
**5426 East 9th Street**
**Tucson, Arizona 95730 (US)**

(74) Representative: **Atchley, Martin John Waldegrave**
**IBM United Kingdom Limited Intellectual Property Department Hursley Park**
**Winchester Hampshire SO21 2JN (GB)**

(54) **Timing signal generator for signal processing system.**

(57)    The present invention relates to a signal processing system comprising a plurality of timing circuits (12, 13, 14) each including a frequency determining portion and means (30) for generating a respective timing signal for use in said signal processing system.

According to the invention the signal processing system is characterised by the provision of a common frequency determining means (40) having predetermined characteristics which in combination with each of the frequency determining portions controls the frequency of the timing signal generated in each timing circuit to a predetermined value., and a plurality of AC coupling-DC blocking circuit means (28) coupling the timing circuits to the common frequency determining means (40) such that there is an ohmic connection between the common frequency determining means (40) and all of the AC coupling-DC blocking circuit means (28).

EP 0 453 253 A2

The present invention relates to timing or clocking circuits which are particularly useful in multi-track data recording and readback systems, such as magnetic tape recorders.

Timing or clocking systems which have a predetermined frequency of operation are useful in systems for recovering and processing data signals recorded on a record member. In such systems all of the tracks of the record member are simultaneously read but the reading functions are independently timed. When certain error inducing situations occur, such as signal drop out (no data read), it is desirable to have the timing or clocking system recover as quickly as possible and to maintain its frequency of operation throughout a defect area. In particular, steps have been tried to improve so called timing or clocking system recovery i.e., generate timing signals based upon the signals being sensed in a multi-tracked system. In such systems, it is desired to reduce average error lengths, enhance clocking system recovery after a defect, improve immunity to synchronisation loss events, improve accelerating tracking capability of the record medium, improve signal to noise ratio in the signal recovery channel, and eliminate high gain loop modes. All of these improvements relate to independent phase lock loops (PLLs) currently used to provide timing or clocking in multi-track and magnetic tape systems.

One problem associated with timing system failure, when the PLLs become out of synchronisation (sync) with the data signals being recovered, is that it prevents the faithful reproduction of the recorded data. This problem continues to be a paramount problem. Many early and current multi-track tape systems, when such timing or clock synchronisation is lost in a track, abort reading that particular track. This read aborting action is referred to as "dead tracking." Resynchronisation bursts are provided for enabling the dead tracked PLL to again become synchronised to signals being received from the record member; then ensuing signals may be successful read. This recovery of phase and frequency synchronisation can pose a problem if the dead tracked PLL shifts its frequency far from the desired readback frequency.

An attempt for enhancing recovery of the PLL operation is shown in the IBM Technical Disclosure Bulletin Vol. 14 No. 3, August, 1971. According to this article, whenever a PLL or variable frequency clock oscillator (VCO) is dead tracked, the dead tracked VCO is then frequency synchronised to a tachometer associated with the record member transport. This action enables coarse synchronisation of the VCO to the record member movement even though all of the VCOs may be dead tracked.

Another approach to ensuring reliable date recovery is by the use of a so-called common clock i.e., one phase lock loop or clock is used for all of the read channels. Each of the channels has a phase adjustment for accommodating skew of the record member. US -A- 4,470,082 and US -A- 4,433,424 show examples of the use of such a common clock. One of the problems with the use of a so-called common clock is that it is expensive, requires high frequency circuits, and has questionable reliability. A much simpler technique of controlling the readback is desired.

The object of the present invention is to provide an improved arrangement for recovering from the failure of one of a plurality of timing circuits in a signal processing system.

The present invention relates to a signal processing system comprising a plurality of timing circuits each including a frequency determining portion and means for generating a respective timing signal for use in said signal processing system.

According to the invention the signal processing system is characterised by the provision of a common frequency determining means having predetermined characteristics which in combination with each of the frequency determining portions controls the frequency of the timing signal generated in each timing circuit to a predetermined value, and a plurality of AC coupling-DC blocking circuit means coupling the timing circuits to the common frequency determining means such that there is an ohmic connection between the common frequency determining means and all of the AC coupling-DC blocking circuit means.

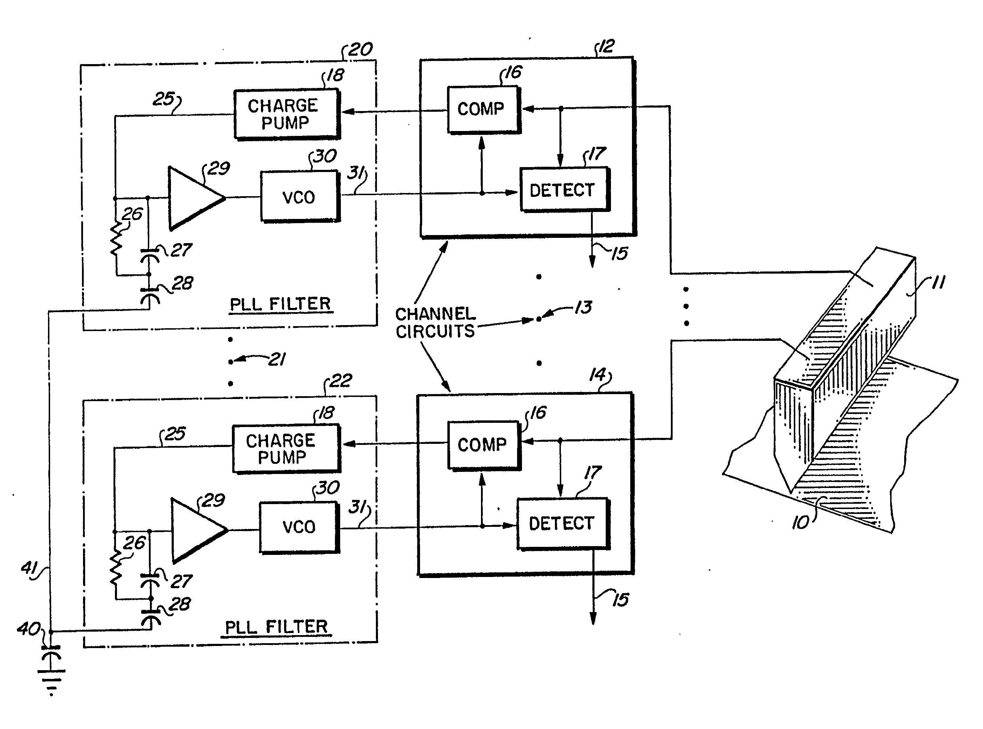

In order that the invention may be more readily understood, an embodiment will now be described with reference to the accompanying drawings in which the sole figure is a combined block and circuit diagram illustrating an embodiment of the present invention in a magnetic tape recording environnent.

Referring now to the drawing, a magnetic tape 10 is suitably transported past a multi-track transducer or head assembly 11. In a preferred construction, head 11 will have both recording and reading portions for each of the record tracks on tape 10. For example, in an 18 track tape, head 11 has 18 combinations of read gaps and write gaps. The invention relates to the frequency control of a reference clock used to generate timing or clock signals for reading data from magnetic tape 10. It is also to be understood that the details of the mechanism for transporting tape 10 and mounting head 11 are not shown for purposes of brevity.

There is one set of channel or readback circuits 12, 13 and 14 for each of the tracks on magnetic tape 10. The channel circuits provide data output over a set of lines 15 which are then phase synchronised for reconstructing the read data, as is known. Each of the channel circuits has its own frequency determining portion 20,21,22 (PLL filter) for generating the reference timing or clock signals. Channel circuits 13 and frequency determining portions (PLL filter) 21 are represented by dots to indicate channel circuits and PLL filters in addition to the circuits 12 and 14 and PLL filters 20 and 22 illustrated. The channel circuits 12 and 14, and the PLL filters 20 and 22 are brought out and expanded for illustrating the invention.

The signals corresponding to the data sensed by the respective portions of head 11 for each of the tracks are processed by the channel circuits 12-14; phase comparator 16 compares the phase of the signal on line 31 supplied by the respective oscillator VCO 30 with the phase of the detector 17 input signal. Charge pump 18 supplies a charge pump signal over line 25. The charge pump signal is supplied through an RC circuit consisting of resistor 26, capacitor 27 and frequency determining capacitor 28 to a buffer amplifier 29 for controlling the frequency of operation of VCO 30. The frequency determining capacitor 28 is coupled to the ground reference potential as described below. Generally, the capacitance value of capacitor 28 is somewhat larger than the capacitance value of capacitor 27. The above design is known in the prior art.

In accordance with the invention, a single capacitor 40 having a capacitance for determining with the capacitors 28 the frequencies of operation of the VCO's 30 is connected to all of the PLL filters 20, 21. and 22 of the system being described. The capacitors 28 have a substantially larger capacitance value than that of the capacitor 40, such as ten times the capacitance value. In this manner, capacitor 40 is AC coupled to all of the PLL filters 20-22 but is DC isolated which enables the individual PLL filters 20-22 to compensate for any differences in VCO gains among the various phase-lock loops. The common capacitor 40 preferably has a capacitance value determined by a multiplicative factor of the number of tracks, i.e. the number VCO's 30 being commonly referenced to this single capacitor 40. For example, for a nine track grouping, the capacitor 40 is nine times the capacitance value of capacitor 28. In a group of eighteen PLL filters 20-22, the common capacitor 40 has eighteen times the capacitance value of the capacitor 28.

The arrangement shown in the drawing gives a global clock effect for all of the channels by coupling together the frequency compensation portions of the PLL filters 20-22 from all the tracks through the coupling capacitors 28. The coupling capacitors 28 provide a DC or direct current blocking and respectively remain charged to the differences between the VCO gain for the respective tracks or channels; the average VCO gain of all of the tracks is coupled together through the common connection 41. Test operations of this circuit have shown that the individual channel circuits 12-14 are enabled to recover data better under marginal conditions by reducing the length of dropouts which then, of course, reduces dead tracking and enhances the recovery data integrity.

While the magnetic tape 10 is being accelerated to operating speed, it has also been found that the frequency tracking of all of the PLLs for all of the tracks is enhanced by the illustrated arrangement. An additional advantage of the illustrated arrangement is that the phase lock loop bandwidth for the individual channel circuits 12-14 can be decreased for improving signal to noise performance. The technique of providing a frequency reference to all of the phase lock loops can be used with other filter topologies or circuit arrangements from those illustrated in the drawing. The simplicity of the arrangement provides an enhanced operation without the attendant additional cost of a common clock or common VCO.

Each of the channel circuits 15 includes a signal detection means 17 which receives the readback signal from head 11 and the clock signal over line 31 from the associated PLL filter. Detection means 17 includes the usual signal detection, error detection correction and other signal processing means found in such channel circuits. Phase comparator 16 compares the frequency in the phase of the clock signal on line 31 with the phase of the readback signal received from head 11. A phase error signal (from charge pump 18) is supplied over line 25 in the usual manner for slaving the operation of VCO 30 to the signal received from head 11. As the quality of the readback signal changes, which can be caused by changes in the speed of tape 10 transport and the like, the VCO 30 may not faithfully follow the frequency and phase of the readback signal. Usually such degraded operation occurs in less than all of the channel circuits 12-14. The arrangement illustrated improves the accommodation of such signal quality variations.

## Claims

1. A signal processing system comprising
   a plurality of timing circuits (12, 13, 14) each including a frequency determining portion (26, 27, 28, 29)and means (30) for generating a respective timing signal for use in said signal processing system,
   characterised by the provision of a
   a common frequency determining means (40) having predetermined characteristics which in combination with each of said frequency determining portions controls the frequency of the timing signal generated in each timing circuit to a predetermined value, and
   a plurality of AC coupling-DC blocking circuit means (28) coupling said timing circuits to said common frequency determining means (40) such that there is an ohmic connection between said common frequency determining means (40) and all of said AC coupling-DC blocking circuit means (28).

2. A signal processing system as claimed in Claim 1 characterised in that said common frequency determining means comprises a common capacitor (40) having a capacitance which, if inserted individually into any one of said timing circuits would cause the timing circuit to generate a timing signal having said predetermined value frequency.

3. A signal processing system as claimed in in Claim 2 characterise.d in that each of said AC coupling-DC blocking circuits means is a single coupling capacitor (28) having an electrical capacitance substantially greater than the capacitance of said common capacitor (40) such that the capacitance of said coupling capacitors do not substantially affect the frequency of operation of said timing circuits.

4. A signal processing system as claimed in Claim 3 in which there are N timing circuits each of which includes a frequency determining capacitor (27), characterised in that the capacitance of said common capacitor (40) is about N times the capacitance of each frequency determining capacitor (27).